# EUROPÄISCHE PATENTANMELDUNG

(11) **EP 3 174 206 A1**
(43) Veröffentlichungstag der Anmeldung: **31.05.2017**
(21) Anmeldenummer: 15195952.5
(22) Anmeldetag: 24.11.2015
(51) Int. Cl.: H03K 17/689, H02H 11/00, H03K 17/06

(54) **DIGITALAUSGABEBAUGRUPPE UND AUTOMATISIERUNGSSYSTEM MIT EINER DIGITALAUSGABEBAUGRUPPE**

(71) Anmelder: Siemens Aktiengesellschaft, 80333 München (DE)
(72) Erfinder: Briemle, Thomas, 92245 Kümmersbruck (DE); Engl, Werner, 92706 Luhe-Wildenau (DE); Grosser, Stefan, 92253 Schnaittenbach (DE); Grünewald, Uwe, 90559 Burgthann (DE)

(57) **Zusammenfassung**

Die Erfindung bezieht sich auf eine Digitalausgabebaugruppe (1) zur Ausgabe digitaler Signale über einen Ansteuerausgang (2) für die Ansteuerung einer Last (L), umfassend einen Versorgungsspannungsanschluss (P24) und einen Masseanschluss (M) zum Anschließen einer ersten Spannungsquelle (V1) für die Baugruppe (1), welche einen Laststrom für die Last (L) bereitstellt, eine Steuerlogik (10), welche ausgestaltet ist ein Halbleiterschaltmittel (11) zu steuern, und das Halbleiterschaltmittel (11) zur Ansteuerung der Last (L) über den Ansteuerausgang (2) mit einem High-Pegel oder einem Low-Pegel ausgestaltet ist, wobei ein Potentialtrennmittel (12) vorgesehen ist um eine zweite Spannungsquelle (V2) für die Versorgung der Steuerlogik (10) von der ersten Spannungsquelle (V1) galvanisch zu trennen, um für den Fall, einer angeschlossenen Last (L) und das ein Low-Pegel am Ansteuerausgang (2) vorherrschen soll, aber auf Grund einer Unterbrechung der über den Masseanschluss (M) hergestellten Masseverbindung zur ersten Spannungsquelle (V1), ein Stromfluss (I_{MB}), ausgehend von dem Versorgungsspannungsanschluss (P24) über die Steuerlogik (10) und das Halbleiterschaltmittel (11) zu dem Ansteuerausgang (2) und weiter über die Last (L) zu einem zentralen Massepunkt (Z_{M}), mit welchem auch die erste Spannungsquelle (V1) in Verbindung steht, zu unterdrücken.

## Beschreibung

Die Erfindung betrifft eine Digitalausgabebaugruppe zur Ausgabe digitaler Signale über einen Ansteuerausgang für die Ansteuerung einer Last, umfassend einen Versorgungsspannungsanschluss und einen Masseanschluss zum Anschließen einer Erstspannungsquelle für die Baugruppe, welche einen Laststrom für die Last bereitstellt, eine Steuerlogik, welche ausgestaltet ist, ein Halbleiterschaltmittel zu steuern, und das Halbleiterschaltmittel zur Ansteuerung der Last über den Ansteuerausgang einen ersten Halbleiterschalter für die Ausgabe eines High-Pegels und einen zweiten Halbleiterschalter für die Ausgabe eines Low-Pegels aufweist.

Des Weiteren betrifft die Erfindung ein Automatisierungssystem aufweisend eine erste Spannungsquelle, eine Automatisierungssteuerung, eine Digitalausgabebaugruppe, und eine Last, wobei die Automatisierungssteuerung ausgestaltet ist, der Digitalausgabebaugruppe zur Ausgabe digitaler Signale über einen Ansteuerausgang für die Ansteuerung der Last einen Steuerbefehl mitzuteilen.

Aus dem Stand der Technik sind Digitalausgabebaugruppen und der Einsatz in Automatisierungssystemen bekannt. Aus dem Datenblatt von Phoenix Contact, IB IL 24 DO 4 ..., Inline-Klemme mit vier digitalen Ausgängen, AUTOMATIONWORX, Datenblatt 5557_de_05, Ausgabe 01/2007 ist eine Digitalausgabebaugruppe bekannt.

Aus dem Datenblatt AB-ASI-M12-DI4DO4-M8-1A (22260759), gültig ab: 05/2009, ist von der Lapp Group die Digitalausgabebaugruppe Automation Bus AS-I-M8-Gerät mit vier digitalen Eingängen und vier digitalen Ausgängen bekannt.

Aus dem Datenblatt der PMA-Prozess- und Maschinen-Automations GmbH für eine Digitalausgabebaugruppe ist die VARIO DO 4/24, I/O-Erweiterungsmodul mit vier digitalen Ausgängen (02/2003) bekannt.

All die bisher bekannten Digitalausgabebaugruppen haben ein gemeinsames Problem, bei einen Massebruch bei einer Masseleitung zu der Digitalausgabebaugruppe kann am Ausgang noch ein Strom von bis zu 25 mA fließen. Bei einem Massebruch kann so ein ungewolltes Verhalten auftreten, da an einem Digitalausgang Strom fließt, obwohl der Digitalausgang abgeschaltet sein soll. Wenn an einem Digitalausgang z.B. ein Digitaleingang angeschlossen ist, erkennt dieser bereits ab 2 mA schon einen High-Pegel. Dies kann zu ungewollten Fehlerfällen bei einem Massebruch einer Masseleitung zu der Digitalausgabebaugruppe in einer Industrieanlage führen.

Bei der bekannten Digitalausgabebaugruppe von Phoenix ist in dem Datenblatt auf Seite 4, ein Ausgangsstrom bei Massebruch von maximal 25 mA beschrieben, bei der bekannten Digitalausgabebaugruppe der Lapp-Automation ist in dem Datenblatt auf Seite 4 ein Ausgangsstrom bei Massebruch im ausgeschalteten Zustand von maximal 5 mA und bei der Digitalausgabebaugruppe der PMA Prozess- und Maschinenautomation ist in dem Datenblatt auf Seite 9 ein Ausgangsstrom bei Massebruch von maximal 25 mA beschrieben.

Es ist Aufgabe der vorliegenden Erfindung die nach dem Stand der Technik bekannten Digitalausgabebaugruppen dahingehend zu verbessern, dass bei einem Massebruch und bei einem abgeschalteten Digitalausgang, also einer Low-Pegel Ansteuerung, über den Ansteuerausgang für eine Last kein Strom fließt.

Die der Erfindung zugrundeliegende Aufgabe wird dadurch gelöst, dass die Digitalausgabebaugruppe zur Ausgabe digitaler Signale über einen Ansteuerausgang für die Ansteuerung einer Last folgende Merkmale umfasst, einen Versorgungsspannungsanschluss und einen Masseanschluss zum Anschließen einer ersten Spannungsquelle für die Baugruppe, welche einen Laststrom für die Last bereitstellt, eine Steuerlogik, welche ausgestaltet ist, ein Halbleiterschaltmittel zu steuern, und das Halbleiterschaltmittel zur Ansteuerung der Last über den Ansteuerausgang einen ersten Halbleiterschalter für die Ausgabe eines High-Pegels und einen zweiten Halbleiterschalter für die Ausgabe eines Low-Pegels umfasst, wobei ein Potentialtrennmittel vorgesehen ist, um eine zweite Spannungsquelle für die Versorgung der Steuerlogik von der ersten Spannungsquelle galvanisch zu trennen, um für den Fall, einer angeschlossenen Last und das ein Low-Pegel am Ansteuerausgang vorherrschen soll, aber aufgrund einer Unterbrechung der über den Masseanschluss hergestellten Masseverbindung zu der ersten Spannungsquelle, ein Stromfluss, ausgehend der ersten Spannungsquelle zu dem Versorgungsspannungsanschluss über die Steuerlogik und das Halbleiterschaltmittel zu dem Ansteuerausgang und weiter über die Last zu einem zentralen Massepunkt, mit welchem auch die erste Spannungsquelle in Verbindung steht, zu unterdrücken.

Eine Ausgestaltungsmöglichkeit sieht vor, dass das Potentialtrennmittel als ein DC/DC-Wandler ausgestaltet ist. In einer weiteren Ausgestaltung weist die Digitalausgabebaugruppe einen Busanschluss mit einer ersten und einer zweiten Busklemme auf, wobei das Potentialtrennmittel für die Versorgung der Steuerlogik an die erste und zweite Busklemme angeschlossen ist, und die zweite Spannungsquelle durch eine Busstromversorgung über den Busanschluss gebildet ist.

In einer Ausgestaltung für die Digitalausgabebaugruppe bei der des Halbleiterschaltmittels aus diskreten Bauteilen aufgebaut ist, ist das Halbleiterschaltmittel wie folgt ausgestaltet, ein erster Halbleiterschalter ist mit einem Source-Anschluss an dem Versorgungsspannungsanschluss und ein zweiter Halbleiterschalter ist mit einem Drain-Anschluss an dem Masseanschluss angeschlossen, ein Drain-Anschluss des ersten Halbleiterschalters und ein Source-Anschluss des zweiten Halbleiterschalters ist an dem Ansteuerausgang angeschlossen, und ein erster Steuerausgang der Steuerlogik ist an einen Gate-Anschluss des ersten Halbleiter-Schalters angeschlossen und ein zweiter Steuerausgang der Steuerlogik ist an einen Gate-Anschluss des zweiten Halbleiterschalters angeschlossen, wobei die Steuerlogik derart ausgestaltet ist, dass sie einen über einen Steuereingang kommenden Schaltbefehl zur Ansteuerung des Ansteuerausgangs mit einem High-Pegel oder einen Low-Pegel umsetzt, wobei für einen High-Pegel der erste Steuerausgang den Gate-Anschluss des ersten Halbleiterschalter ansteuert und für einen Low-Pegel der zweite Steuerausgang den Gate-Anschluss des zweiten Halbleiterschalters ansteuert.

Im Hinblick auf eine induktiv belastete Last ist es von Vorteil, wenn der zweite Halbleiterschalter zwischen dem Drain-Anschluss und dem Source-Anschluss eine Diode aufweist, und bei induktiven Lasten einen Teil eines Freilaufstrompfades beim Abschalten der induktiven Last bildet.

Die eingangs genannte Aufgabe wird ebenso durch ein Automatisierungssystem gelöst, wobei das Automatisierungssystem eine erste Spannungsquelle, eine Automatisierungssteuerung, eine Digitalausgabebaugruppe und eine Last aufweist, wobei die Automatisierungssteuerung ausgestaltet ist, der Digitalausgabebaugruppe zur Ausgabe digitaler Signale über einen Ansteuerausgang für die Ansteuerung der Last einen Steuerbefehl mitzuteilen, die Digitalausgabebaugruppe ist über einen Versorgungsspannungsanschluss und einen Masseanschluss an der ersten Spannungsquelle angeschlossen, die Last ist zum einen an dem Ansteuerausgang und zum anderen an einen zentralen Massepunkt angeschlossen, die Digitalausgabebaugruppe weist weiterhin eine Steuerlogik und ein Halbleiterschaltmittel auf, wobei die Steuerlogik ausgestaltet ist, das Halbleiterschaltmittel zu steuern, und das Halbleiterschaltmittel ist wiederum zur Ansteuerung der Last über den Ansteuerausgang mit einem ersten Halbleiterschalter für die Ausgabe eines High-Pegels und mit einem zweiten Halbleiterschalter für die Ausgabe eines Low-Pegels ausgestaltet, wobei ein Potentialtrennmittel vorgesehen ist um eine zweite Spannungsquelle für die Versorgung der Steuerlogik von der ersten Spannungsquelle galvanisch zu trennen, das für den Fall, einer Unterbrechung der über den Masseanschluss hergestellten Masseverbindung zur ersten Spannungsquelle, ein Stromfluss, ausgehend von dem Versorgungsspannungsanschluss über die Steuerlogik und das Halbleiterschaltmittel zu dem Ansteuerausgang und weiter über die Last zu den zentralen Massepunkt, mit welchem auch die erste Spannungsquelle in Verbindung steht, ausbleibt.

Anhand von den in der Zeichnung dargestellten Ausführungsbeispielen soll die Erfindung sowie vorteilhafte Ausgestaltungen, Verbesserungen und weitere Vorteile der Erfindung näher erläutert und beschrieben werden. Es zeigt
- FIG 1: das Funktionsprinzip einer Digitalausgabebaugruppe nach dem Stand der Technik,
- FIG 2: das Funktionsprinzip der Digitalausgabebaugruppe nach dem Stand der Technik bei Massebruch,
- FIG 3: eine verbesserte Digitalausgabebaugruppe und
- FIG 4: ein Automatisierungssystem mit einer Digitalausgabebaugruppe.

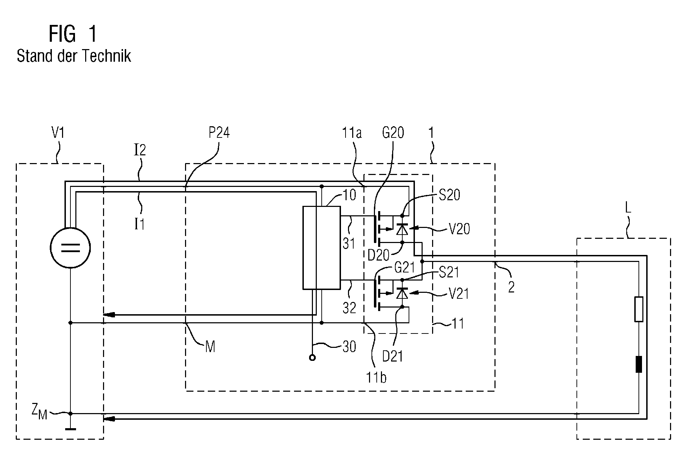

Gemäß der FIG 1 ist eine Digitalausgabebaugruppe 1 nach dem derzeit bekannten Stand der Technik zur Ausgabe digitaler Signale über einen Ansteuerausgang 2 für die Ansteuerung einer Last L dargestellt. Die Digitalausgabebaugruppe 1 ist über einen Versorgungsspannungsanschluss P24 und einem Masseanschluss M an einer ersten Spannungsquelle V1 angeschlossen. An dem Ansteuerausgang 2 ist eine Last L mit einem ersten Anschluss angeschlossen, wobei ein zweiter Anschluss der Last L zu einem zentralen Massepunkt Z_{M} führt, welcher ebenfalls mit dem Masseanschluss M der ersten Spannungsquelle V1 in Verbindung steht. Die Digitalausgabebaugruppe 1 weist eine Steuerlogik 10 auf, welche zur Versorgung mit einer Versorgungsspannung mit dem Versorgungsspannungsanschluss P24 und dem Masseanschluss M über jeweils eine Anschlussleitung in Verbindung steht. Die Steuerlogik 10 weist einen ersten Steuerausgang 31 und einen zweiten Steuerausgang 32 auf. Der erste Steuerausgang 31 und der zweite Steuerausgang 32 sind an ein Halbleiterschaltmittel 11 angeschlossen. Als Ausgang weist das Halbleiterschaltmittel 11 den Ansteuerausgang 2 auf. Über den ersten Steuerausgang 31 gibt die Steuerlogik 10 dem Halbleiterschaltmittel 11 einen Schaltbefehl zur Ansteuerung der Last L mit einem High-Pegel vor. Über den zweiten Steuerausgang 32 gibt die Steuerlogik 10 dem Halbleiterschaltmittel 11 einen Steuerbefehl zur Ansteuerung der Last L mit einem Low-Pegel vor. Das Halbleiterschaltmittel 11 ist dabei wie folgt ausgestaltet, ein erster Halbleiterschalter V20 ist mit einem Source-Anschluss S20 an dem Versorgungsspannungsanschluss P24 und ein zweiter Halbleiterschalter V21 ist mit einem Drain-Anschluss D21 an dem Masseanschluss M angeschlossen. Ein Drain-Anschluss D20 des ersten Halbleiterschalters V20 und ein Source-Anschluss S21 des zweiten Halbleiterschalters V21 ist an dem Ansteuerausgang 2 angeschlossen. Der erste Steuerausgang 31 der Steuerlogik 10 ist an einen Gate-Anschluss G20 des ersten Halbleiterschalters V20 angeschlossen und der zweite Steuerausgang 32 der Steuerlogik 10 ist an einen Gate-Anschluss G21 des zweiten Halbleiterschalters V21 angeschlossen.

Die Steuerlogik 10 ist dabei derart ausgestaltet, dass sie einen über einen Steuereingang 30 kommenden Schaltbefehl zur Ansteuerung des Ansteuerausgangs 2 mit einem High-Pegel oder einem Low-Pegel umsetzt, wobei für einen High-Pegel der erste Steuerausgang 31 den Gate-Anschluss G20 des ersten Halbleiterschalters V20 ansteuert und für einem Low-Pegel der zweite Steuerausgang den Gate-Anschluss G21 des zweiten Halbleiterschalters V21 ansteuert.

Um einen eigenen Verbrauch der Steuerlogik 10 bzw. der elektronischen Komponenten der Baugruppe aufzuzeigen, ist ein erster Strompfad I1 eingezeichnet. Der erste Strompfad I1 startet von der ersten Spannungsquelle V1 über den Versorgungsspannungsanschluss P24 und gelangt über entsprechende Zuleitungen in die Steuerlogik 10 und über eine entsprechende Zuleitung aus der Steuerlogik 10 heraus zu dem Masseanschluss M. Der Masseanschluss M steht wiederum mit einer Masse der ersten Spannungsquelle V1 in Verbindung. Die Steuerlogik 10 ist damit zum Ausführen ihrer Betriebsfunktion an die erste Spannungsquelle V1 zur Versorgung angeschlossen.

Wird nun das Halbleiterschaltmittel 11 über die Steuerlogik 10 derart angesteuert, dass ein High-Pegel an der Last L ausgegeben werden soll, nämlich der erste Halbleiterschalter V20 wird leitend angesteuert, so bildet sich ein zweiter Strompfad 12 aus. Dieser zweite Strompfad 12 kennzeichnet den Laststrom bei einem High-Pegel. Der zweite Strompfad 12 ist ebenfalls in die Zeichnung eingezeichnet und startet bei der ersten Spannungsquelle V1 und gelangt über den Versorgungsspannungsanschluss P24 in die Digitalausgabebaugruppe 1. Über einen Schaltspannungsanschluss 11a des Halbleiterschaltmittels 11 gelangt die Versorgungsspannung der ersten Versorgungsspannungsquelle V1 bzw. der Laststrom an das Halbleiterschaltmittel 11. Der zweite Strompfad 12 kann damit durch das Halbleiterschaltmittel 11 über die Source-Drain-Strecke des ersten Halbleiterschalters V20 an den Ansteuerausgang 2 gelangen. Über den Ansteuerausgang 2 führt der zweite Strompfad 12 über die Last L zu einen zentralen Massepunkt Z_{M}, wobei der zentrale Massepunkt Z_{M} wiederum an die erste Spannungsquelle V1 angeschlossen ist und mit dem Masseanschluss M in Verbindung steht.

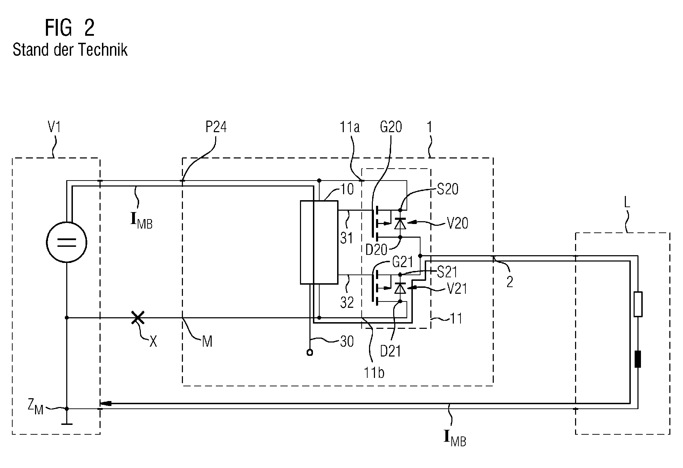

Mit der FIG 2 ist der nach dem Stand der Technik vorherrschende kritische Fall dargestellt, ein Massebruch der Masseverbindung von der ersten Spannungsquelle V1 zum Masseanschluss M der Digitalausgabebaugruppe 1 und einem gleichzeitigen gewollten Ausgeben eines Low-Pegels für die Last L. Der kritische Fall ergibt sich dadurch, dass nun am Ansteuerausgang 2 ein Low-Pegel vorherrschen soll, aber zwischen der ersten Spannungsquelle V1 und dem Masseanschluss M eine Unterbrechung X aufgetreten ist. Nun kann sich ein Stromfluss I_{MB} bei Massebruch durch die Unterbrechung X derart einstellen, dass obwohl die Last L nicht angesteuert werden darf, ca. 20 mA durch die Last L fließen. Der Stromfluss I_{MB} bei Massebruch startet bei der ersten Spannungsquelle V1 geht über den Versorgungsspannungsanschluss P24 in die Digitalausgabebaugruppe 1 herein und fließt über die Steuerlogik 10 zu der internen Versorgungsleitung, welche an den Masseanschluss M der Digitalausgabebaugruppe 1 angeschlossen ist, gelangt damit zu dem Drain-Anschluss des zweiten Halbleiterschalters V21, fließt über den Source-Anschluss S21 zu dem Ansteuerausgang 2 und schließlich über die Last L zu dem zentralen Massepunkt Z_{M}. Dieser Stromfluss I_{MB} bei Massebruch ist nicht gewollt.

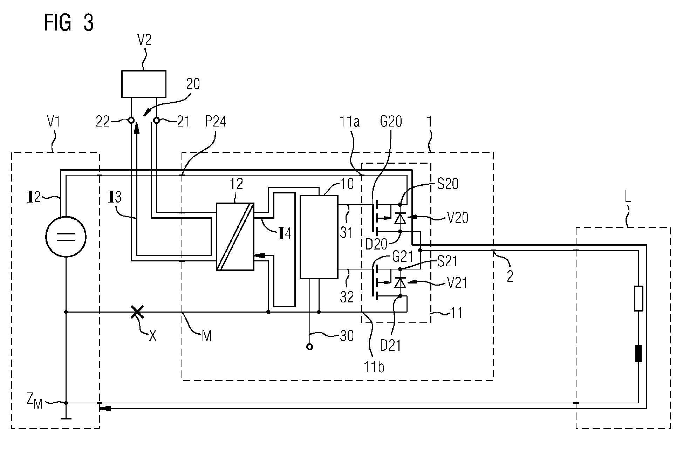

Um einen ungewollten Stromfluss I_{MB} bei einer Unterbrechung X der Verbindung zwischen einer Masse der ersten Spannungsquelle V1 und dem Masseanschluss M der Digitalausgabebaugruppe 1 zu unterbinden, ist mit der FIG 3 eine Digitalausgabebaugruppe 1 mit einen Potentialtrennmittel 12 dargestellt. Das Potentialtrennmittel 12 ist vorgesehen, um eine zweite Spannungsquelle V2 für die Versorgung der Steuerlogik 10 von der ersten Spannungsquelle V1 galvanisch zu trennen. Denn aufgrund dieser Potentialtrennung kann ein ungewollter Stromfluss I_{BM} bei einer Unterbrechung X der Masseverbindung zur ersten Spannungsquelle V1 ausgeschlossen werden. Die Steuerlogik 10 ist nun nicht mehr zur Versorgung mit einer Betriebsspannung an den Versorgungsspannungsanschluss P24 der Digitalausgabebaugruppe 1 angeschlossen.

Das Potentialtrennmittel 12, ausgestaltet als ein DC/DC-Konverter weist eine Primärseite und eine Sekundärseite auf. Die Primärseite ist mit einem ersten Anschluss und mit einem zweiten Anschluss an einen Busanschluss 20 angeschlossen. Eine erste Busanschlussklemme 21 und eine zweite Busanschlussklemme 22 stehen dazu zur Verfügung. Das Potentialtrennmittel 12 erhält somit eine Versorgungsspannung aus einer Betriebsspannung für eine Busstromversorgung. Es bildet sich ein dritter Strompfad 13 aus, welcher den Eigenverbrauch der Digitalausgabebaugruppe 1 bzw. der Steuerlogik 10 kennzeichnet. Der dritte Strompfad 13 ist demnach als Eigenverbrauch der Baugruppe im Primärkreis des Potentialtrennmittels 12 anzusehen. Auf der Sekundärseite des Potentialtrennmittels 12 bildet sich ein vierter Strompfad 14 aus, welcher als Eigenverbrauch der Baugruppe auf der Sekundärseite des Potentialtrennmittels 12 anzusehen ist. Zwar ist die Steuerlogik 10 noch mit ihrer internen Verbindungsleitung an dem Masseanschluss M angeschlossen, aber die Versorgung der Steuerlogik 10 mit einer Versorgungsspannung geschieht nun nicht mehr über den Versorgungsspannungsanschluss P24, sondern über das Potentialtrennmittel 12 und damit über eine separate zweite Spannungsquelle V2.

Bei einer Unterbrechung X der Masseverbindung zwischen der ersten Spannungsquelle V1 und dem Masseanschluss M der Digitalbaugruppe 1 kann sich für das Schalten der Last L immer noch der zweite Strompfad 12 (Laststrom bei High-Pegel) ausbilden, aber der ungewollte Stromfluss I_{MB} bei Massebruch (siehe FIG 2) kann bei der Digitalausgabebaugruppe 1 nach FIG 3 nicht mehr auftreten. Da die Versorgungsspannung für die Steuerlogik 10 nun keinen äußeren Bezug, insbesondere keinen Bezug zum zentralen Massepunkt Z_{M}, mehr hat, kann kein Strom mehr über die Last L bei einer Unterbrechung X fließen.

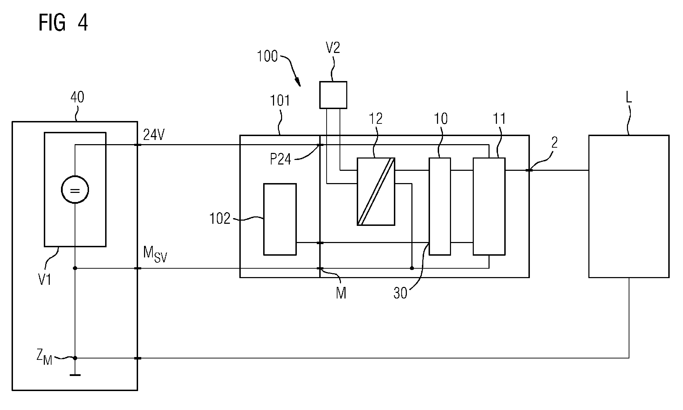

Mit der FIG 4 ist ein Automatisierungssystem 100 dargestellt. Eine erste Spannungsquelle V1 ist innerhalb eines Schaltschrankes 40 angeordnet. Die erste Spannungsquelle V1 weist einen 24V-Anschluss und einen Masseanschluss M_{SV} auf. Der 24V-Anschluss wird durch eine Automatisierungssteuerung 101 an den Versorgungsspannungsanschluss P24 der Digitalausgabebaugruppe 1 geführt. Der Masseanschluss M_{SV} der ersten Spannungsquelle V1 wird ebenfalls durch die Automatisierungssteuerung 101 an einen Masseanschluss M der Digitalausgabebaugruppe 1 geführt. Die Automatisierungssteuerung 101 weist einen Mikroprozessor 102 auf, welcher ausgestaltet ist, der Steuerlogik 10 über den Steuereingang 30 Schaltbefehle für das Schalten der Last L mitzuteilen. Die Steuerlogik 10 ist über das Potentialtrennmittel 12 von der ersten Spannungsquelle V1 galvanisch getrennt und erhält seine Betriebsspannung zur Versorgung der Steuerlogik 10 über die zweite Spannungsquelle V2. Die Last L ist an den Ansteuerausgang 2 und an eine zentrale Masse, nämlich an den zentralen Massepunkt Z_{M} im Schaltschrank 40 angeschlossen.

## Patentansprüche

1. Digitalausgabebaugruppe (1) zur Ausgabe digitaler Signale über einen Ansteuerausgang (2) für die Ansteuerung einer Last (L), umfassend
einen Versorgungsspannungsanschluss (P24) und einen Masseanschluss (M) zum Anschließen einer ersten Spannungsquelle (V1), welche einen Laststrom für die Last (L) bereitstellt, eine Steuerlogik (10), welche ausgestaltet ist ein Halbleiterschaltmittel (11) zu steuern, und das Halbleiterschaltmittel (11) zur Ansteuerung der Last (L) über den Ansteuerausgang (2) einen ersten Halbleiterschalter (V20) für die Ausgabe eines High-Pegels und einen zweiten Halbleiterschalter (V21) für die Ausgabe eines Low-Pegels aufweist, wobei ein Potentialtrennmittel (12) vorgesehen ist um eine zweite Spannungsquelle (V2) für die Versorgung der Steuerlogik (10) von der ersten Spannungsquelle (V1) galvanisch zu trennen, um für den Fall, einer angeschlossenen Last (L) und das ein Low-Pegel am Ansteuerausgang (2) vorherrschen soll, aber auf Grund einer Unterbrechung (X) der über den Masseanschluss (M) hergestellten Masseverbindung zu der ersten Spannungsquelle (V1), ein Stromfluss (I_{MB}), ausgehend von der ersten Spannungsquelle (V1) zu dem Versorgungsspannungsanschluss (P24) über die Steuerlogik (10) und das Halbleiterschaltmittel (11) zu dem Ansteuerausgang (2) und weiter über die Last (L) zu einem zentralen Massepunkt (Z_{M}), mit welchem auch die erste Spannungsquelle (V1) in Verbindung steht, zu unterdrücken.

2. Digitalausgabebaugruppe (1) nach Anspruch 1, wobei das Potentialtrennmittel (12) als ein DC/DC-Wandler ausgestaltet ist.

3. Digitalausgabebaugruppe (1) nach Anspruch 1 oder 2, aufweisend einen Busanschluss (20) mit einer ersten und zweiten Busklemme (21,22), wobei das Potentialtrennmittel (12) für die Versorgung der Steuerlogik (10) an die erste und zweite Busklemme (21,22) angeschlossen ist und die zweite Spannungsquelle (V2) durch eine Busstromversorgung über den Busanschluss (20) gebildet ist.

4. Digitalausgabebaugruppe (1) nach einem der Ansprüche 1 bis 3, wobei das Halbleiterschaltmittel (11) wie folgt ausgestaltet ist, der erste Halbleiterschalter (V20) ist mit einem Source-Anschluss (S20) an dem Versorgungsspannungsanschluss (P24) und der zweite Halbleiterschalter (V21) ist mit einem Drain-Anschluss (D21) an dem Masseanschluss (M) angeschlossen, ein Drain-Anschluss (D20) des ersten Halbleiterschalters (V20) und ein Source-Anschluss (S21) des zweiten Halbleiterschalters (V21) ist an dem Ansteuerausgang (2) angeschlossen, und ein erster Steuerausgang (31) der Steuerlogik (10) ist an einem Gate-Anschluss (G20) des ersten Halbleiter-Schalters (V20) angeschlossen und ein zweiter Steuerausgang (32) der Steuerlogik (10) ist an einem Gate-Anschluss (G21) des zweiten Halbleiterschalters (V21) angeschlossen, wobei die Steuerlogik (10) derart ausgestaltet ist, das sie einen über einen Steuereingang (30) kommenden Schaltbefehl zur Ansteuerung des Ansteuerausgangs (2) mit einem High-Pegel oder einem Low-Pegel umsetzt, wobei für einen High-Pegel der erste Steuerausgang (31) den Gate-Anschluss (G20) des ersten Halbleiterschalters (V20) ansteuert und für einen Low-Pegel der zweite Steuerausgang (32) den Gate-Anschluss (G21) des zweiten Halbleiterschalters (V21) ansteuert.

5. Digitalausgabebaugruppe (1) nach Anspruch 4, wobei der zweite Halbleiterschalter (V21) zwischen dem Drain-Anschluss (D21) und dem Source-Anschluss (S21) eine Diode aufweist, und diese bei induktiven Lasten einen Teil eines Freilaufstrompfades beim Abschalten der induktiven Last bildet.

6. Automatisierungssystem (100) aufweisend
eine erste Spannungsquelle (V1),
eine Automatisierungssteuerung (101),
eine Digitalausgabebaugruppe (1),
eine Last (L),
wobei die Automatisierungssteuerung (101) ausgestaltet ist der Digitalausgabebaugruppe (1) zur Ausgabe digitaler Signale über einen Ansteuerausgang (2) für die Ansteuerung der Last (L) einen Steuerbefehl mitzuteilen,
die Digitalausgabebaugruppe (1) ist über einen Versorgungsspannungsanschluss (P24) und einen Masseanschluss (M) an der ersten Spannungsquelle (V1) angeschlossen,
die Last (L) ist zum einen an dem Ansteuerausgang (2) und zum anderen an einem zentralen Massepunkt (Z_{M}) angeschlossen,
die Digitalausgabebaugruppe (1) weist weiterhin eine Steuerlogik (10) und ein Halbleiterschaltmittel (11) auf, wobei die Steuerlogik (10) ausgestaltet ist das Halbleiterschaltmittel (11) zu steuern, und das Halbleiterschaltmittel (11) ist zur Ansteuerung der Last (L) über den Ansteuerausgang (2) mit einem ersten Halbleiterschaltmittel (V20) für die Ausgabe eines High-Pegels und mit einem zweiten Halbleiterschaltmittel (V21) für die Ausgabe eines Low-Pegels ausgestaltet, mit einem High-Pegel oder einem Low-Pegel,
wobei ein Potentialtrennmittel (12) vorgesehen ist um eine zweite Spannungsquelle (V2) für die Versorgung der Steuerlogik (10) von der ersten Spannungsquelle (V1) galvanisch zu trennen, dass für den Fall, einer Unterbrechung der über den Masseanschluss (M) hergestellten Masseverbindung zur ersten Spannungsquelle (V1) ein Stromfluss (I_{MB}) ausgehend von dem Versorgungsspannungsanschluss (P24) über die Steuerlogik (10) und das Halbleiterschaltmittel (11) zu dem Ansteuerausgang (2) und weiter über die Last (L) zu dem zentralen Massepunkt (Z_{M}), mit welchem auch die erste Spannungsquelle (V1) in Verbindung steht, ausbleibt.
